# EUROPEAN PATENT APPLICATION

(11) **EP 2 498 290 A1**
(43) Date of publication of application: **12.09.2012**
(21) Application number: 11157881.1
(22) Date of filing: 11.03.2011
(51) Int. Cl.: H01L 25/07, H05K 3/34, H01L 23/498, H01L 23/00, H01L 21/607

(54) **Contact element and power semiconductor module comprising a contact element**

(71) Applicant: ABB Research Ltd., 8050 Zürich (CH)
(72) Inventor: Riedel, Gernot, 5406 Baden-Rütihof (CH); Schulz, Nicola, 5300 Turgi (CH)
(74) Representative: ABB Patent Attorneys

(57) **Abstract**

The present invention relates to a contact element for contacting a power semiconductor device (38) and being configured for carrying currents of at least 10 A, the power semiconductor device (38) being preferably arranged in a power semiconductor module (34), wherein the contact element (22) is at least partly "L"-shaped and comprises a first arm (24) for fixing the contact element (22) to a conductor (14) on a substrate (12), and a second arm (26) for electrically interconnecting the contact element (22) with a contact device, wherein the first arm (24) comprises at least two recesses (28) proceeding in the plane of the first arm (24). A Contact element (22) according to the invention is easy to form and has improved stress reducing properties as well as reliability properties.

## Description

### Technical Field

The present invention relates to a contact element for contacting a power semiconductor device. The present invention further relates to a power semiconductor arrangement comprising such a contact element. The present invention further relates to a power semiconductor module comprising such a power semiconductor arrangement.

### Background Art

A variety of semiconductor modules, such as power semiconductor modules, are known and used in many different electronic devices. For forming, or manufacturing, respectively, a semiconductor module, different electric parts of the latter have to be contacted with each other to provide an interlinked internal structure. Additionally, it is required to provide an external contact to connect one or more electric parts of the semiconductor module to an external contact device.

As an example, to achieve an external electrical contact with the semiconductor module, it is widely known to provide a terminal as a contact element and to solder it on top of a metallization of a ceramic substrate. Terminals of power electronic (PE) modules are required to transfer large electrical currents. A major drawback of the known soldering technique is a limited reliability under thermal and mechanical cycling of the soldered connection between terminal and substrate. Therefore, the connection and thus the whole semiconductor module have a limited lifetime only, and furthermore soldered connections only withstand limited operation temperatures.

It is therefore known to overcome this problem by replacing the soldered connection between one or more contacts of a semiconductor module, e.g. the contact element and the metallization on the substrate, by a welded connection. In particular, ultrasonic waves, or energy respectively, are used for forming a welded connection. Further attachment methods could include brazing or other welding methods such as laser or micro-resistance welding. In any case, the mechanical connection between the contact element and the substrate metallization is significantly stronger than using a soldered joint.

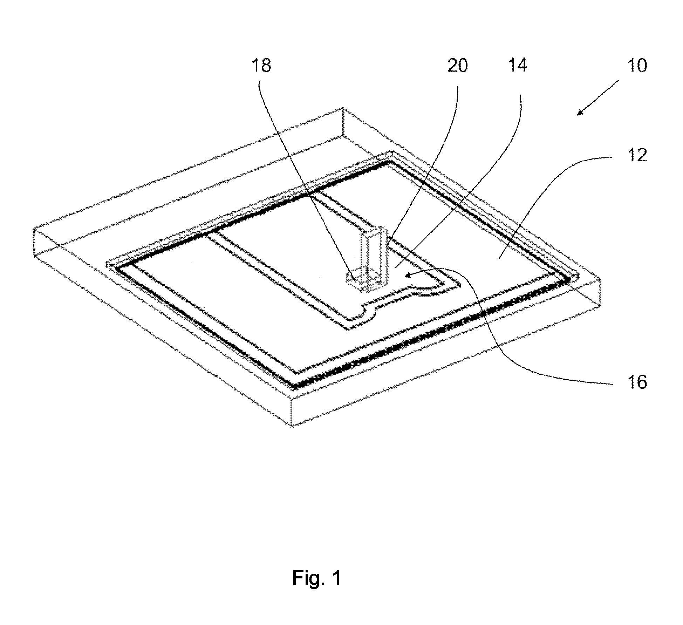

A typical power semiconductor arrangement 10 known from the state of the art is shown in figure 1. The power semiconductor arrangement 10 comprises a substrate 12 with a structure of electrical conductors 14 provided on the substrate 12. The conductors 14 are for example formed by a metallization. A contact element 16 is attached to one of the conductors 14. The contact element 16 is at least partly "L"-shaped. It thus comprises a first arm 18 and a second arm 20. The contact element 16 may be formed of copper, for example. Copper has a higher coefficient of thermal expansion (CTE) (α=16E-6 /K) compared to the most ceramic substrates (e.g. AlN α = 4.7E-6 /K). Due to the mismatch in the coefficient of thermal expansion between the contact element 16 and the ceramic substrate 12, thermo-mechanical stress is induced when changing the module temperature, i.e. when cycling occurs. Stress appears especially at the metallization-substrate interface and, depending on the connection, within the substrate solder, potentially resulting in substrate cracking or metallization/solder delamination.

Further contact elements could be attached to the same conductor 14 as the contact element 16 shown in figure 1 or to further electrical conductors provided on the substrate 12.

Known from EP 1 713 124 A2 is a power semiconductor module comprising a contact element as a metallic shaped part with at least one end section, wherein each end section extends perpendicular to an associated connection track and is butt soldered with at least one contact surface to this connecting track, wherein the contact surface is constructed as a plurality of partial contact surfaces. Such a contact element has the object to reduce the stress by sharing the stress induced to partial contact surfaces.

Known from US 2008/0153321 A1 is an electrical terminal for a power semiconductor module. This terminal is designed for providing improved mechanical flexibility to avoid stress due to thermal expansion during operation of the module. For this purpose, the terminal comprises a connection element which electrically connects a first contact with a second contact, the connection element comprising a springy portion with at least one bended area or at least one bending and a linear portion arranged between the second electrical contact and the springy portion, wherein the at least one bended area or the at least one bending comprises at least one diminution.

Known from DE 197 52 408 A1 is a power module comprising a connector frame with an end section comprising a cutting at the bottom of said end section for improving the flexibility of said end section.

However, under some circumstances, the connection of the contact element to the substrate may be instable leading to a decreased reliability, and the stress reducing properties might be insufficient.

### Summary of invention

It is an object of the present invention to provide an improved contact element, an improved power semiconductor arrangement comprising the same and an improved power semiconductor module comprising said arrangement having improved stress reducing properties, reliability properties, and/or is easy to form.

This object is achieved by a contact element according to claim 1. This object is furthermore achieved by a power semiconductor arrangement according to claim 10. This object is furthermore achieved by a power semiconductor module according to claim 11. Preferred embodiments of the present invention are defined in the dependent claims.

The invention relates to a contact element for contacting a power semiconductor device and being configured for carrying currents of at least 10 A, the power semiconductor device being preferably arranged in a power semiconductor module, wherein the contact element is at least partly "L"-shaped and comprises a first arm for fixing the contact element to a conductor on a substrate, and a second arm for electrically interconnecting the contact element with a contact device, wherein the first arm comprises at least two recesses proceeding in the plane of the first arm.

According to the invention, an at least partly "L"-shaped contact element shall mean that at least the bottom part, where the contact element is fixable to the conductor on the substrate, or its metallization, respectively, is "L"-shaped. The first arm may thereby easily be fixed to the conductor e.g. by exercising a pressing force on the latter in a well defined manner, thereby applying ultrasonic energy to weld the first arm, or the contact element, respectively, to the conductor. Due to the "L"-shaped form of the contact element, the second arm is located spaced apart from the substrate because of which it may easily be interconnected with an external contact device. At this side of the second arm which is spaced apart from the first arm, different structures of the contact element may follow.

Furthermore, an L"-shaped form thereby shall mean a design in which the first and second arms are arranged substantially rectangular with respect to each other. However, the contact element may deviate from the rectangular shape if the first arm lies substantially plane on the substrate and the second arm proceeds such, that its end is spaced apart from the plane of the substrate, so that an interconnection may easily be made.

The first arm and the second arm may thereby be formed in one piece, the piece being bended between the two arms forming the latter. Alternatively, it is possible to form the first arm and the second arm out of two pieces, the latter being connected at their ends.

According to the invention, the contact element is configured for carrying currents of at least 10A. It is thus designed as a terminal for externally contacting the metallic layer, or the power semiconductor device, respectively, to an external contacting device. It is thus part of the power current path of the power semiconductor module. In order to be configured for carrying currents of at least 10A, the contact element may particularly be formed in defined dimensions. Exemplary dimensions which might be used for a contact element to carrying currents of at least 10A may comprise a thickness of ≥ 0,5mm to ≤ 4mm and a width of ≥ 2,5mm to ≤ 10mm.

According to the invention, the first arm comprises at least two recesses proceeding in the plane of the first arm. This enables the stress, especially thermo-mechanical stress being introduced, especially by mechanical or thermal cycling, to be reduced to a factor ≥ 2 in the ceramic substrate and in a substrate and/or solder layer. The recesses thus act as a geometrical stress reducing structure, or stress releasing structure, respectively.

Due to the fact that the recesses are proceeding in the plane of the first arm, they are very well suited to reduce the stress being exerted to the contact element, or the substrate, respectively. In detail, they allow the first arm to be locally less rigid which significantly reduces the stress occurring.

The recesses may thereby have any form suitable like described down below.

Due to the fact that the contact element is at least partly "L" shaped, a big contact area between the contact element, or its first arm, respectively, and the conductor on the substrate may be provided. This enables a secure and reliable connection leading to a high durability of a semiconductor module equipped with a contact element according to the invention.

Additionally, it is possible to attach the contact element to a substrate conductor substantially without limitations with respect to the applied connection technique. It is well possible to use ultrasonic welding procedures, for example by using a sonotrode. Thereby, a force may be applied to the upper side of the first arm thereby enabling a strong joint to be formed between the contact element and the substrate conductor.

Another advantage lies in the low costs which are required for forming a contact element according to the invention. In detail, the processes for forming the contact element and the recesses are simple and do not require complex arrangements. In contrast thereto, the recesses are easy and simple to form and may be very well adapted to the special application, i.e. the exact geometry and size of the contact element, for example.

Consequently, according to the invention, the geometry of the contact element is optimized in order to reduce the stress induced. This results in damages within the substrate solder, the substrate and/or the contact element close to the metallization/substrate interface to be prevented and thus in an improved reliability.

In a preferred embodiment of the present invention, at least one recess is provided on the upper side of the first arm. According to this embodiment, the stress releasing, or stress reducing, properties of the at least one recess are further improved compared to a recess being formed at the lower side of the first arm, resulting in a further improved reliability of the contact element. It is especially preferred that all recesses are provided at the upper side of the first arm.

The upper side, or top side, respectively, of the first arm shall thereby mean the side being opposed to the side being connectable to the substrate, or its metallization, respectively. Consequently, the upper side lies adjacent to the second arm.

Additionally, a structure at the top, or upper side of the first arm may serve as an optical guide to position a connecting tool, such as a welding tool, for example a sonotrode, directly above the foot, or first arm, for the welding process. Consequently, the welding process is simplified resulting in improved process conditions. In detail, the processing time for welding and the precision of the connection of the welding connection, or the position of the contact element on the substrate, is improved. This allows the semiconductor module according to the invention being manufactured in an easy way without the requirement of a highly complex apparatus arrangement thereby being manufactured in a well reproducible manner.

Additionally, the recesses provided in the first arm have no negative influence on the welded joint strength and the electrical current carrying capability of the first arm and the contact element as such. In contrast thereto, these properties remain unchanged which is particular advantageous for an application in power semiconductor modules as in these modules high currents have to be conducted. This is due to the fact that the connected area, for example the welded area, is not reduced and furthermore the conducting volume or the current density is not significantly influenced in an undesired manner.

In a further preferred embodiment of the present invention, at least one recess is formed as a groove being square, "V"-shaped, or "U"-shaped. According to the invention, a "V"-shaped groove shall mean a groove having a sharp bottom, whereas an "U"-shaped groove has a rounded bottom. The above kinds of recesses, or grooves, respectively, are especially easy to form allowing the contact element according to the invention to be produced in a cost saving manner. Additionally, grooves of the above identified form exhibit good stress reducing properties.

With this regard, it is especially preferred that the groove has a depth in the range of ≥ 10% to ≤100%, in particular in the range of ≥ 40% to ≤100% with respect of the thickness of the first arm. It is most likely preferred that the groove is adapted to the dimension of the contact element as such, or its first arm, respectively. Exemplary grooves may therefore exhibit a depth in the range of ≥ 0,2mm to ≤ 1,0mm, in particular of 0,5mm. These kinds of grooves are easy to prepare and furthermore exhibit good stress reducing properties.

It is furthermore preferred that at least one recess proceeds through the whole length, width, and/or thickness of the first arm. If, for example, the recess extends through the whole width and/or length of the first arm, it thus proceeds from one side to the other side. If the recess proceeds through the whole thickness of the first arm, it proceeds from its top to its bottom. A recess extending through the whole thickness thereby acts as a gap separating the first arm into sub portions. As an example, if a recess proceeds through the whole length and the whole thickness of the first arm, the contact zone is designed as two separated contact zones. Such recesses show further improved stress reducing properties.

In a still further preferred embodiment of the present invention, two recesses are provided being arranged crosswise. This is an especially advantageous embodiment because the induced stress may be reduced with respect to two directions being substantially perpendicular to each other. Consequently, the stress reducing properties of this embodiment are especially advantageous.

In a further preferred embodiment of the present invention, a plurality of recesses is provided being arranged in parallel to each other. According to this embodiment, again good stress reducing properties may be achieved.

In a still further embodiment of the present invention, the second arm comprises at least one recess. This embodiment allows reducing the stress not only in the first arm, but also at the second arm. Consequently, the stress is reduced in the whole contact element, or at least in the bottom part of it which is formed "L"-shaped. Consequently, the stress reducing capacity is further improved.

It is furthermore preferred that the first arm has a thickness in a range of ≥ 0,5mm to ≤ 3mm. This allows high currents to be conducted through the first arm and thus through the contact element which is especially suitable for applications in power semiconductor modules. Additionally, such a thickness allows forming recesses substantially without limitations due to a good stability of the first arm.

The invention further relates to a power semiconductor arrangement comprising a substrate, a conductor provided on the substrate, a power semiconductor device and a contact element according to the invention, wherein the first arm of the contact element is fixed to the conductor on the substrate. The power semiconductor arrangement thus comprises a power semiconductor device. Examples for power semiconductor devices comprise in a non limiting manner diodes and transistors, like Insulated Gate Bipolar Transistors (IGBT). Especially in a power semiconductor arrangement a contact element according to the invention is advantageous because especially high electrical loads have to be conducted leading to strong cycling conditions. The electrical loads are of at least 10 A or even more.

According to the invention, the power semiconductor arrangement may comprise a substrate, for example made from a ceramic material and a metallization located thereon as conductor. The metallization may be connected to the contact element by any known connection technique. However, a welding connection is especially preferred due to the improved durability and strength of this connection. This as well improves the reliability properties of a semiconductor module according to the invention.

In detail, a welding connection may sustain temperatures of 200°C or more and a power semiconductor arrangement may be manufactured according to this embodiment without the requirement of consumables like solder or bond wires leading to advantages with respect to the environmental point of view.

By welding the contact element to the metallization, furthermore a highly conductive connection is formed. This makes the semiconductor arrangement according to the invention being particularly suitable for power applications in which high amounts of electric currents have to be conducted through this connection.

The invention further relates to a power semiconductor module comprising a power semiconductor arrangement according to the invention.

A power semiconductor arrangement comprising a contact element according to the invention or a power semiconductor module comprising a power semiconductor arrangement according to the invention does thus not exhibit disadvantages related to cycling. With respect to the present invention, cycling means an influence of periodically changing conditions, especially with respect to temperature and/or mechanical influence. Thus, the power semiconductor arrangement as well as the power semiconductor module according to the invention provides improved properties with respect to reliability as well as durability.

**Brief description of drawings**

Additional features, characteristics and advantages of the subject-matter of the invention are disclosed in the subclaims, the figures and the following description of the respective figures and examples, which -in an exemplary fashion- show embodiments and examples of a contact element according to the invention.

In the figures:

Figure 1 shows a schematic view of a semiconductor arrangement with a contact element according to the state of the art;

Figure 2 shows a schematic view of a contact element according to one embodiment of the present invention;

Figure 3 shows the v. Mises stress within a middle layer of a substrate solder to show the effect of using a contact element according to the invention;

Figure 4 shows a schematic view of a further embodiment of a first arm of a contact element according to the present invention;

Figure 5 shows a schematic view of a further embodiment of a first arm of a contact element according to the present invention;

Figure 6 shows a schematic view of a further embodiment of a first arm of a contact element according to the present invention;

Figure 7 shows a schematic view of a further embodiment of a first arm of a contact element according to the present invention;

Figure 8 shows a schematic view of a further embodiment of a first arm of a contact element according to the present invention; and

Figure 9 shows a schematic view of a further embodiment of a first arm of a contact element according to the present invention; and

Figure 10 shows a power semiconductor module according to the invention.

### Description of embodiments

In the following, the invention is described in detail with respect to different embodiments in which the same or comparable elements are referred to with the same reference signs.

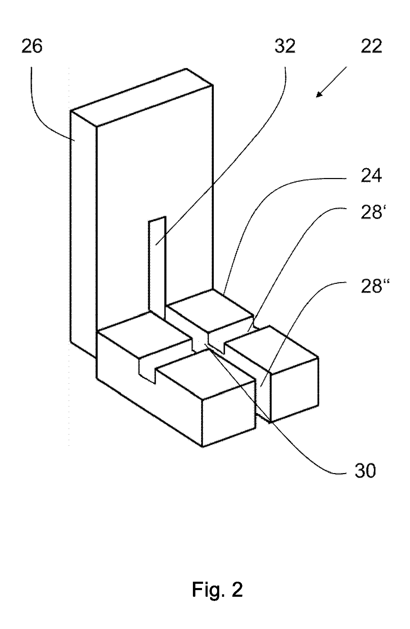

According to figure 2, a contact element 22 according to the invention is schematically shown. The contact element 22 may preferably be formed of copper but may be formed from any material being appropriate. In detail, the bottom part of the contact element 22 is shown which is designed to be connected to a conductor 14 provided on a substrate 12 of a power semiconductor arrangement 10 as shown in figure 1. Instead of a known contact element 16 as shown in figure 1 the contact element 22 according to the invention is used. With this regard, the contact element 22 is at least partly "L"-shaped and comprises a first arm 24 for connecting the contact element 22 to one of the conductors 14 provided on the substrate 12 and a second arm 26 for interconnecting the contact element 22 with a contact device. The contact device, not shown as such, may be an external contact device or a contact device of an electronic element inside a power semiconductor module.

According to the invention, the contact element 22 comprises at least two recesses 28 proceeding in the plane of the first arm 24. According to figure 2, two recesses 28 are provided in the first arm 24. Further, if the contact element 22 is attached to the conductor 14 the plane is preferably at least approximately parallel to the surface of the substrate 12.

Generally, the at least two recesses 28 may be adapted to the desired arrangement of the contact element 22 as well as substrate 12. Consequently, at least one recess 28 may proceed through the whole length, width, and/or thickness of the first arm 24 and may furthermore be provided on the upper side and/or at the bottom side of the first arm 24.

If provided on the same side of the first arm 24, the at least two recesses 28 may be arranged parallel or they may have a point of intersection 30. In the latter case, the two recesses 28 may be arranged crosswise, for example.

Additionally, the recesses 28 may be formed as grooves being square, "V"-shaped, or "U"-shaped. In an alternative case, the recesses 28 may proceed through the whole thickness of the first arm 24 and may thus be present on both sides of the first arm 24, i.e. on its top side as well as on its bottom side. At the bottom side the contact element 22 is to be connected to the conductor 14 provided on the substrate 12 of the power semiconductor arrangement 10. In detail, one a contact element 22 is connected to one conductor 14, or a plurality of contact elements is connected to one conductor 14.

With respect to its dimensions, the recesses 28 may have a depth being independently from each other and the depth may lie in the range of ≥ 0,2mm to ≤ 1,0mm in particular of 0,5mm. However, it is mostly preferred that the dimensions of the recesses 28 are adapted to the dimensions of the contact element 22 as such. It is thus preferred that the recesses 28 have a depth in the range of ≥ 10% to ≤100%, in particular in the range of ≥ 40% to ≤100% with respect of the thickness of the contact element.

According to figure 2, a first recess 28' of the two recesses 28 proceeds through the whole width of the first arm 24 and is provided, or opened, respectively, on the upper side of the first arm 24. It is thus formed as a groove and furthermore as a groove being square shaped. A second recess 28" of the two recesses 28 proceeds through the whole length of the first arm 24 and additionally through the whole thickness of the first arm 24. The second recess 28" thus forms a separation of two parts forming the first arm 24. According to figure 2, the recesses 28 are arranged crosswise and have a point of intersection 30 substantially in the middle of the first arm 24.

In an exemplary manner, the thickness of the contact element 22, i.e. the thickness of the first arm 24 as well as of the second arm 26 is 1,5mm, whereas the width is 5mm. The first recess 28' has a depth of 0,5mm. The second recess 28" has a width of 1 mm and furthermore proceeds through the whole thickness of the first arm, thus forming two partial sections of the first arm 24 having dimensions of 2mm (width) X 4mm (length). The contact element 22 like described above may be used for power semiconductor modules such as an IGBT module, for example.

The contact element 22 according to the invention is part of the main current path of the power semiconductor arrangement 10. In the main current path, which is at least partially formed by the conductor 14 to which the contact element 22 is attached, at least one power semiconductor device is arranged. If an IGBT is used as the at least one power semiconductor device, the main current path is connected to the collector terminal and to the emitter terminal of the IGBT, in case of diodes, the main current path is connected to the anode and the cathode of the diode. In general, the anode and the cathode of the at least one power semiconductor device are in the main current path.

In case at least one three terminal power semiconductor device is used in the semiconductor module, the three terminal power semiconductor has an anode terminal, a cathode terminal and a driving terminal (i.e. gate terminal or base terminal), and the semiconductor module is also provided with a driving circuit arrangement connected to the driving terminal of the power semiconductor device.

The power semiconductor device as used for the power semiconductor arrangement according to the invention is a diode, a Metal Oxide Semiconductor Field-Effect Transistor (MOSFET), an Insulated Gate Bipolar Transistor (IGBT), a Bi-Mode Insulated Gate Transistor (BIGT), or a Reverse Conductive IGBT (RC IGBT), for example.

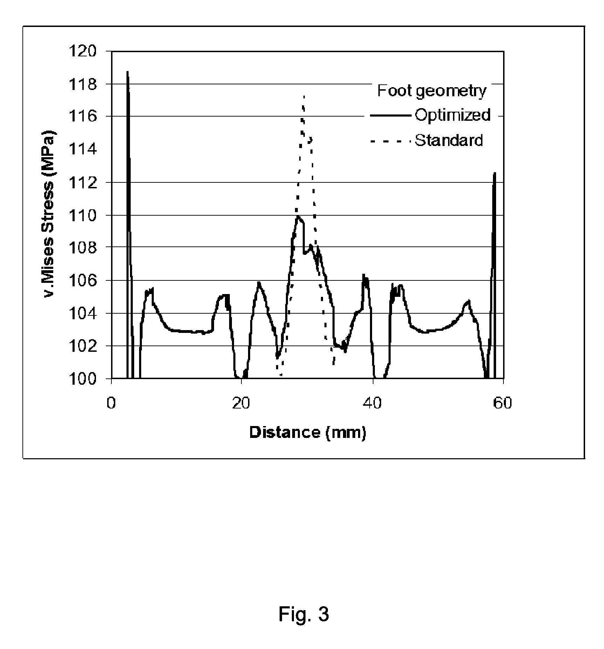

The effect of equipping a semiconductor arrangement 10 with a contact element 22 according to the embodiment of figure 2 is visualized in figure 3. According to figure 3, the thermo mechanical von Mises stress was simulated within a middle substrate solder along the x-axis arranged between the conductor 14 and the power semiconductor contact element 22. The simulation data was obtained by assuming a uniform temperature of 125°C with a reference, i.e. stress free, temperature of 25°C. A standard semiconductor module was used. According to figure 3, the stress along the x-axis, passing underneath the contact element 22 is plotted for reason of quantification of the effect being reached by using a contact element 22 according to the invention. The stress induced by the contact element 22, i.e. the height of the peak with respect to the background is reduced from 13MPa to 6MPa due to the provision of the stress reducing structures according to the invention. The arrow indicates the position of the terminal foot, wherein the dotted line represents the usage of a contact element 16 according to the state of the art and the continuous line represents the usage of a contact element 22 according to the invention.

Consequently, finite element modelling (FEM) shows that the stress induced within the substrate solder can be reduced by more than a factor 2 when changing the standard terminal foot geometry (Fig. 1) to an optimized one (Fig. 2).

Further embodiments of the contact element 22 according to the invention are shown in the following figures. In detail, only the first arm 24 is shown. However, it is of obvious for one skilled in the art that the shown respective first arms 24 are connected to a second arm 26 and furthermore may be connected to the metallization of a substrate 12 of a semiconductor arrangement 10.

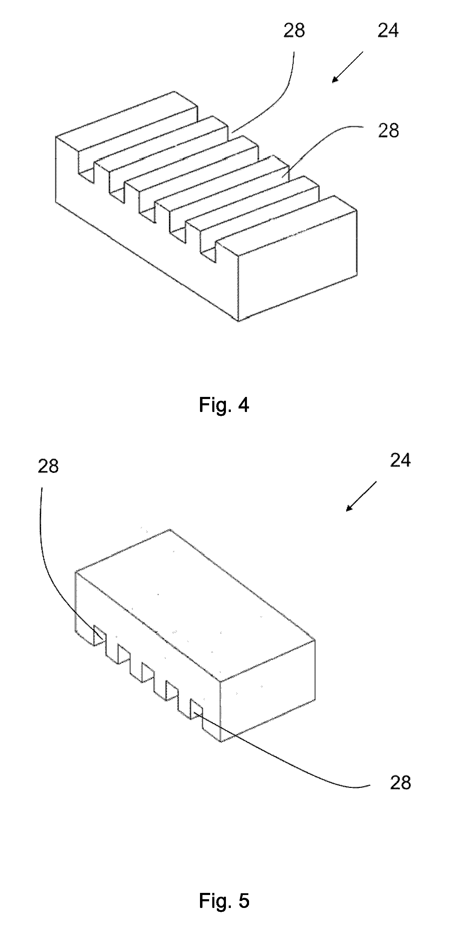

According to figure 4, a plurality of recesses 28 is provided which proceed through the whole width of the first arm 24. The recesses 28 are arranged in parallel to each other and are provided on the top side of the first arm 24. Furthermore, the recesses 28 are formed as grooves, particularly as square grooves.

The embodiment according to figure 5 corresponds to the embodiment according to figure 4, wherein the recesses 28 are provided at the bottom side of the first arm 24.

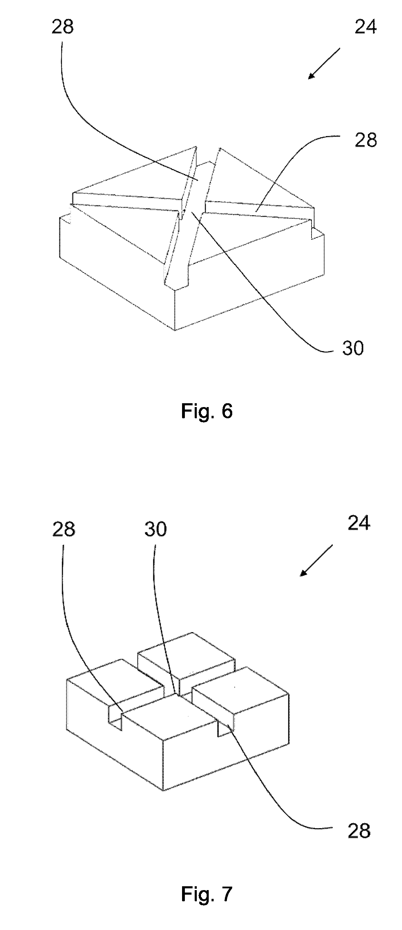

According to figure 6, two square-shaped recesses 28 are provided on the top side of the first arm 24. The recesses 28 are not arranged in parallel, but they are arranged crosswise. In detail, the recesses 28 proceed from and to the respective edges of the first arm 24 and thus have a point of intersection 30.

The embodiment according to figure 7 corresponds to the embodiment of figure 6 with the difference, that the recesses 28 are rotated in an angle of 45°. They are thus proceeding along the length and along the width of the first arm 24.

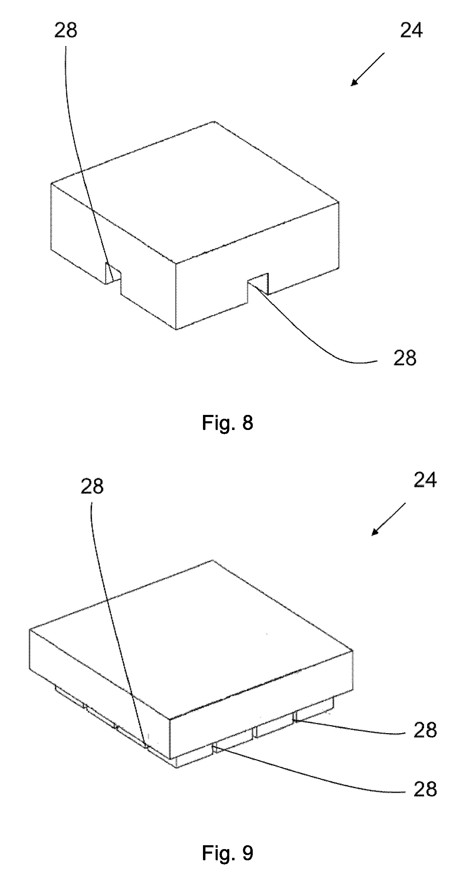

The embodiment according to figure 8 corresponds to the embodiment according to figure 7 with the difference that the recesses 28 are provided at the bottom side of the first arm 24.

According to figure 9, a plurality of recesses 28 is provided parallel both along the length and along the width of the first arm 24. The recesses 28 are thereby arranged at the bottom side of the first arm 24. Consequently, a structure of a plurality of parallel recesses 28 and a plurality of points of intersection 30 is formed.

It has to be noted that the structure being formed by arranging the recesses may be varied by combining the features like described above in a way being appropriate for the respective application without leaving the invention. For example, the depth, shape and location of the recesses may be combined in any way.

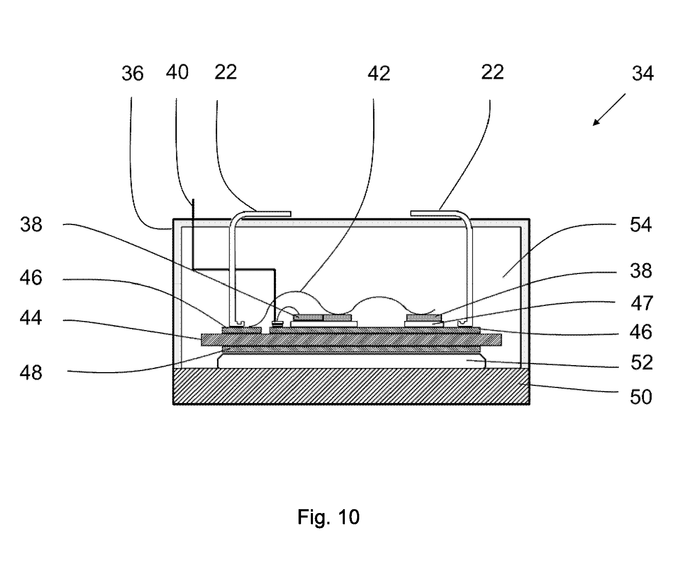

In a further embodiment of the present invention, the power semiconductor arrangement 10 is used in a power semiconductor module 34 as shown in figure 10. Typically, in such a power semiconductor module 34 more than one power semiconductor arrangement 10 are arranged in parallel in order to increase the total current carry capability of the module 34. However, it is also possible that only one power semiconductor arrangement 10 is arranged in the power semiconductor module 34.

In figure 10, a power semiconductor module 34 according to the invention is schematically shown. In detail, the internal structure of said semiconductor module 34 is described. The semiconductor module 34 comprises a housing 36 in which at least one power semiconductor device 38 is arranged. The power semiconductor device 38 may in a preferred example be an insulated gate bipolar transistor (IGBT), a diode, a metal oxide semiconductor field-effect transistor (MOSFET), or the like. According to figure 10, a diode and an IGBT are provided as power semiconductor devices 38. The semiconductor device 38 or the plurality of semiconductor devices 38 are connectable via contact terminals, or contact elements 22, respectively, and preferably via an auxiliary terminal 40. In detail, the contact elements 22 may serve as en emitter terminal and as a collector terminal, whereas the auxiliary terminal 40 may serve as a gate. The semiconductor device 38 or the plurality of semiconductor devices 38 is preferably bonded by aluminium bond wires 42.

The semiconductor device 38 may further be arranged on a substrate 44, or wafer, respectively, which may be formed of a ceramic insulator, in particular of an aluminium nitride ceramic insulator. In detail, the contact elements 22 as well as the auxiliary terminal 40 are connected to a metallization 46 provided on the substrate 44, in particular a copper metallization. Connected to the metallization 46 via a solder 47 is in turn the power semiconductor device 38. Additionally, the substrate 44 is connected at its bottom side to a to a base plate 50 via a further metallization 48, in particular a copper metallization, and via a solder 52. The remaining volume inside the housing 36 is filled e.g. with a silicone gel 54. The high power semiconductor devices 38 are capable of blocking at least 300 V and carrying currents of at least 100 A.

In order to connect the power semiconductor module 34 to an electrical circuit the contact elements 22 can be guided to the outside of the housing 36 of the power semiconductor module 34 as shown in figure 10. In an alternative embodiment not shown in the figures, the contact element 22 is electrically connected to a power terminal of the module 34 for connecting the power semiconductor module 34 to an electrical circuit.

While the invention has been illustrated and described in detail in the drawings and foregoing description, such illustration and description are to be considered illustrative or exemplary and not restrictive, the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

### Reference Signs List

- 10: semiconductor arrangement
- 12: substrate
- 14: conductor
- 16: contact element
- 18: first arm
- 20: second arm
- 22: contact element
- 24: first arm
- 26: second arm
- 28: recess
- 30: point of intersection
- 32: recess
- 34: power semiconductor module
- 36: housing
- 38: power semiconductor device
- 40: auxiliary terminal
- 42: aluminium bond wires
- 44: substrate
- 46: metallization
- 47: solder
- 48: metallization
- 50: base plate
- 52: solder
- 54: silicone gel

## Claims

1. Contact element for contacting a power semiconductor device (38) and being configured for carrying currents of at least 10 A, the power semiconductor device (38) being preferably arranged in a power semiconductor module (34), wherein the contact element (22) is at least partly "L"-shaped and comprises a first arm (24) for fixing the contact element (22) to a conductor (14) on a substrate (12), and a second arm (26) for electrically interconnecting the contact element (22) with a contact device, wherein the first arm (24) comprises at least two recesses (28) proceeding in the plane of the first arm (24).

2. Contact element according to claim 1, wherein at least one recess (28) is provided on the upper side of the first arm (24).

3. Contact element according to claim 1 or 2, wherein at least one recess (28) is formed as a groove being square, "V"-shaped, or "U"-shaped.

4. Contact element according to claim 3, wherein the groove has a depth in the range of ≥ 10% to ≤100%, in particular in the range of ≥ 40% to ≤100%, with respect of the thickness of the first arm (24).

5. Contact element according to any of the preceding claims, wherein at least one recess (28) proceeds through the whole length, width, and/or thickness of the first arm (24).

6. Contact element according to any of the preceding claims, wherein two recesses (28) are provided being arranged crosswise.

7. Contact element according to any of the preceding claims, wherein a plurality of recesses (28) is provided being arranged in parallel to each other.

8. Contact element according to any of the preceding claims, wherein the second arm (26) comprises at least one recess (32).

9. Contact element according to any of the preceding claims, wherein the first arm (24) has a thickness in the range of ≥0,5mm to ≤3mm.

10. Power semiconductor arrangement, comprising a substrate (12), a conductor (14) provided on the substrate (12), a power semiconductor device, and a contact element (22) according to any of the preceding claims, wherein the first arm (24) of the contact element (22) is fixed to the conductor (14) on the substrate (12).

11. Power semiconductor module comprising a power semiconductor arrangement (10) according to claim 11.
